# EUROPEAN PATENT SPECIFICATION

(11) **EP 0 685 882 B1**
(45) Date of publication and mention of the grant of the patent: **21.02.2001**
(21) Application number: 95303698.5
(22) Date of filing: 31.05.1995
(51) Int. Cl.: H01L 21/76

(54) **Semiconductor device incorporating an isolation trench and manufacture thereof**
Halbleiteranordnung mit einem Isolationsgraben und Verfahren zur Herstellung
Dispositif semi-conducteur comportant une rainure d'isolation et procédé de fabrication

(30) Priority: 31.05.1994 GB 9410874
(43) Date of publication of application: 06.12.1995
(73) Proprietor: STMicroelectronics Limited, Bristol BS12 4SQ (GB)
(72) Inventor: Evans, Dylan Wyn, South Glamorgan CF4 3JX, Wales (GB); Guite, David Ralph, Bernin 28190, (FR); Henry, Martin Andrew, Crolles 38920, (FR)
(74) Representative: Jenkins, Peter David

(56) References cited:
- EP-A- 0 375 632
- WO-A-87/00687
- PATENT ABSTRACTS OF JAPAN vol. 9 no. 266 (E-352) [1989] ,23 October 1985 & JP-A-60 111436 (TOSHIBA K.K.) 17 June 1985,
- JOURNAL OF THE ELECTROCHEMICAL SOCIETY, vol. 134, no. 2, February 1987 MANCHESTER, NEW HAMPSHIRE US, pages 500-502, K. SAGARA ET AL. 'EVALUATION OF DISLOCATION GENRATION IN SILICON SUBSTRATES BY SELECTIVE OXIDATION OF U-GROOVES'

## Description

The present invention relates to a semiconductor device incorporating an isolation trench and to a method of manufacturing a semiconductor device incorporating an isolation trench.

In semiconductor technology, it is known electrically to isolate adjacent devices, such as transistors, on a semiconductor chip by using an isolation oxide. The use of isolation oxide gives rise to a number of problems, particularly when small devices are present in the chip and are closely spaced. The isolation oxide is not planar, thereby reducing the planarisation of the semiconductor device. Furthermore, the use of isolation oxide can give rise to step coverage problems, which militates against reduction of the device size. Local isolation oxidation schemes are inherently limited in their use for isolating devices with small active-active region spacings of less than about 2 microns.

It is known to provide isolation trenches between adjacent devices in order to permit the isolation width to be reduced. In known arrangements, all or part of the region of the silicon substrate between adjacent devices, such as transistors, is removed to form a trench which is then filled up with dielectric or undoped material, for example silicon oxide or polysilicon and then the device is planarised. This can give improved isolation as compared to isolation oxide. With known isolation trenches, unwanted electrical conduction can occur around the bottom of the trench, particularly if charges are present at the edge of the silicon in the vicinity of the trench. The trench is desirably as deep as possible to avoid electrical conduction around it. However, the depth of the trench is limited by its width. For the manufacture of DRAMs, there is typically provided a depth:width aspect ratio of 10:1. However, in order to reduce device size and thereby to reduce manufacturing costs, it is desirable for the trench to be made shallower thereby to reduce the width thereof, but whilst still retaining a sufficient degree of isolation.

In order to avoid conduction around the bottom of the trench, the threshold voltages for initiating such conduction should be typically around 15 to 20 volts for a 5V supply voltage, being at least double the supply voltage. If the threshold voltage is exceeded, the semiconductor structure in the vicinity of the trench can act as a parasitic transistor. In order to control i.e. increase the sidewall threshold voltages (Vt), the sidewalls of the trench are doped. Such doping can be achieved by implantation or by diffusion. For implantation, the sidewalls of the trench are implanted at a selected angle which requires the silicon wafer to be implanted four or more times at different flat orientations in an implantation apparatus or the use of very complex and expensive ion implantation equipment in order to be able to rotate each wafer, whilst maintaining a constant angle to the wafer surface. This is costly and time consuming. For diffusion, for example, from a doped oxide, this process provides inherently less control over the doping of the sidewall as compared to implantation, because of the imprecise nature of the diffusion process giving less control over the sidewall threshold voltage.

EP-A-0375632 discloses a semiconductor device and a method of manufacturing a semiconductor device having the features of the pre-characterizing portion of claims 1 and 4 respectively.

The present invention aims to provide an improved isolation trench in a semiconductor device and an improved method of producing such an isolation trench in a semiconductor device.

The prevent invention provides a semiconductor device comprising a silicon substrate, two spaced active areas in a surface of the substrate, an isolation trench of isolating material located between the active areas and extending downwardly into the silicon substrate, the isolating material including a layer of silicon oxide adjacent to the silicon substrate, the interface between the layer of silicon oxide and the silicon substrate at the top of the isolation trench being rounded, and a body of insulating material filling the remainder of the trench, and a doped area comprising a threshold voltage adjusting region which surrounds the isolation trench, the isolation trench having sidewalls and a bottom wall, the doped area having an implanted dopant which has been implanted into the sidewalls and bottom wall of the isolation trench, characterised in that the sidewalls are inwardly tapered at an angle of from 5 to 20° to the vertical, and the isolation trench has a depth of from 0.5 to 5.0 microns and a width of around 0.8 microns.

The present invention still further provides a method of manufacturing a semiconductor device incorporating an isolation trench, the method comprising the steps of: (a) providing a silicon substrate, a lower silicon oxide layer over the substrate and an etch stop layer over the silicon oxide layer; (b) etching an isolation trench downwardly into the etch stop layer, the silicon oxide layer and the silicon substrate, the etching being carried out whereby the isolation trench has sidewalls and a bottom wall; (c) implanting an implant into the sidewalls and bottom wall of the isolation trench; (d) filling the trench with isolating material by growing silicon oxide in the trench adjacent the silicon substrate and filling the remainder of the trench with a body of insulation material, the layer of silicon oxide in the isolation trench being grown so as to be joined with the lower silicon oxide layer at junctions along opposed sides of the trench whereby the conjoined oxide layer has an increased thickness portion thereof at the junctions; and (e) at any stage in the method, defining active areas in the silicon substrate which are on opposed sides of the isolation trench in the resultant semiconductor device, characterised in that the etching step (b) is carried out whereby the sidewalls are inwardly tapered at an angle of from 5 to 20° to the vertical and the isolation trench has a depth of from 0.5 to 5.0 microns and a width of around 0.8 microns and the implanting step (c) uses a single implant substantially perpendicular to the upper surface.

Embodiments of the present invention will now be described by way of example only, with reference to the accompanying drawings, in which:
FIGS. 1 to 4 show sections through a semiconductor device illustrating a sequence of steps for manufacturing an isolation trench; and
FIGS. 5 to 10 show sections through a semiconductor device illustrating a sequence of steps in a process for producing an isolation trench in accordance with an embodiment of the present invention.

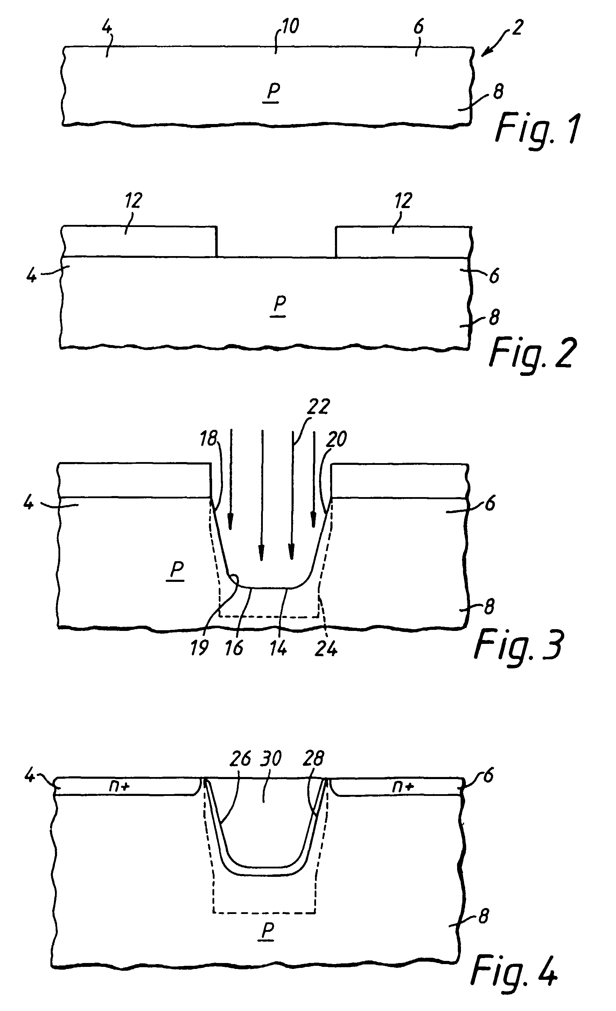

Referring to Figure 1, a semiconductor wafer structure, designated generally as 2, includes a pair of regions 4,6 which are provided in the surface of a silicon substrate 8 and are separated by a region 10 of the silicon substrate 8.

The regions 4,6 are to constitute active area regions to be separated by an isolation trench and in general the trench isolation region 10 and the active area regions 4,6 are defined at the same time such that regions not defined as a trench will be defined as active area. In accordance with the present invention, an isolation trench is formed in the silicon substrate 8, by removing the surface region 10 between the regions 4,6 so as, in the final device, electrically to isolate the two regions 4,6 which have been subsequently doped in the manner described hereinafter.

Referring to Figure 2, a masking layer 12 of photoresist is patterned in known manner over the two regions 4,6 so as to expose the surface region 10 of the substrate 8 between the two regions 4,6 as shown in Figure 2.

Referring now to Figure 3, an isolation trench 14 is then etched into the substrate 8, the location of the isolation trench 14 being defined between the edges of the photoresist layer 12. In accordance with the present invention, the isolation trench 14 has a substantially horizontal bottom wall 16 and two downwardly and inwardly tapering side walls 18,20. As is described hereinafter, the provision of tapered sidewalls 18,20 for the trench 14 permits all orientations of the sidewalls 18,20 to be simultaneously implanted using a single implant perpendicular to the wafer surface.

The taper of the sidewalls 18,20 can be adjusted. In addition the angle of the taper down the sidewalls 18,20 can be varied in particular by providing a rounding 19 at the bottom of the isolation trench 14 in order to improve subsequent refill of the trench 14 with dielectric material. However, the sidewalls 18,20 must not be re-entrant at any point as this would prevent subsequent doping of the sidewalls 18,20 by the implant. The trench etch is preferably carried out by dry plasma etching in a chlorine based chemistry, with the conditions chosen to control the profile of the sidewalls 18,20 of the trench at an angle in the range of from 5 to 20° to the vertical, more typically from 8 to 15° to the vertical. The isolation trench 14 is etched to a depth in the range of from 0.5 to 5.0 microns, more typically from 0.8 to 3.0 microns. The isolation trench has a width of around 0.8 microns. The minimum separation permitted by circuit design rules is dependent upon the particular circuit layout.

Referring again to Figure 3, after the isolation trench 14 has been formed, a "channel stop" or "threshold voltage adjust" implant is then formed so as to implant ions into the sidewalls 18,20. The ion implantation parameters are adjusted, in combination with the taper of the sidewalls 18,20, to give optimum control of the sidewall threshold voltages. As represented by the arrows 22 in Figure 3, the implant is performed using a single, zero degree i.e. vertical implant. The tapered sidewall construction permits all orientations of the sidewalls to be simultaneously implanted using a single implant. The use of ion implantation perpendicular to the wafer results in an increased dopant level at the bottom of the trench 14 which aids in the removal of unwanted minority charge carriers. The dopant concentration in the sidewalls 18,20 is determined by the dose and energy of the ion implant and the angle of the sidewalls 18,20. The doped area 24 surrounding the isolation trench 14 is indicated by a dashed line in Figure 3.

In a typical isolation trench production process in accordance with the present invention, the isolation trench 14 is etched to a depth of 1.0 microns with a sidewall angle of 12° and the channel stop implant has a dose of 2.4 x 10¹³ ions cm⁻² using the BF2⁺ ion at an energy of around 55 keV. Such conditions are sufficient to isolate adjacent active area regions separated by 0.8 microns, representing the width of the isolation trench 14, with a threshold voltage greater than 28 volts. Boron could be implanted at a lower energy so as to provide a similar effect. The BF2⁺ ion gives a shallower implant than the the B⁺ ion.

Subsequently, a heat treatment is carried out to activate the implant surrounding the isolation trench 14.

In accordance with the present invention, the "threshold voltage adjust" implant prevents the formation of an inversion layer, i.e. the inversion of a p-doped region into an n-doped region, between the n⁺-regions 4,6, near the surface of the silicon substrate 8 which can cause current leakage between the adjacent active areas 4,6. Such a problem is of particular concern in lightly doped p-type silicon where a p-type ion implant would be used, but is also applicable for n-type implants (P or As for example) into n-type silicon.

Referring to Figure 4, the masking layer 12 is removed in known manner and subsequently a thin oxide layer 26 is grown in the isolation trench 14 so as to passivate the trench surface 28. The thin oxide layer 26 preferably has a thickness of from 50 to 500 X10⁻¹⁰m. The thin oxide layer 26 covers etch and implant damage, taking up surface states so as to provide a low level of states in the trench surface 28. As is also shown in Figure 4, subsequently a dielectric layer 30 is filled in the isolation trench 14 in known manner for example by a blanket deposition process with a subsequent etch back or chemical mechanical polishing process so as to complete the isolation between the two active regions 4,6. The tapered shape of the trench 14 readily permits re-fill of the trench 14 even for small trench widths of less than 1 micron.

Thereafter, the regions 4,6 are doped by implantation so as to be highly doped and so as to constitute doped active areas which are separated electrically by the isolation trench 14. The regions 4,6 may be source or drain regions of adjacent transistors. In the illustrated embodiment, the two regions 4,6 are n⁺-doped regions and the substrate 8, initially including the region 10, is p-doped. It will be apparent to a man skilled in the art that the present invention is equally applicable to other doping arrangements, for example the regions 4,6 being p⁺-doped and the substrate 8 being n-doped.

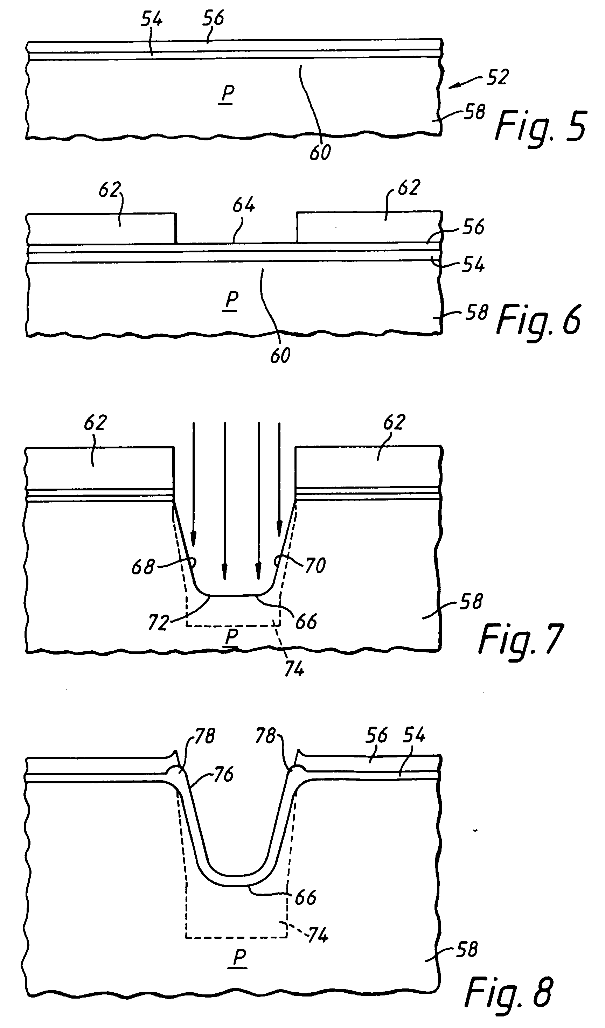

The manufacture of an isolation trench in a semiconductor device in accordance with an embodiment of the present invention is illustrated in Figures 5 to 10. In this embodiment, the isolation trench is formed in a silicon substrate before the definition of active areas on opposed sides of the trench, which active areas are intended to be electrically isolated by the trench.

Referring to Figure 5, a semiconductor wafer structure, designated generally as 52, comprises a p-doped silicon substrate 58 including a central surface region 60 thereof which is intended to be removed in the formation of a trench between two active areas subsequently to be defined in opposed regions of the silicon substrate 58. The silicon substrate 58 has deposited or grown thereover, in turn, a silicon oxide layer 54 preferably having a thickness of from 100 to 750 x10⁻¹⁰m, more typically around 500 x10⁻¹⁰m, and a silicon nitride layer 56 having a thickness preferably of from 500 to 2000 X10⁻¹⁰m, more typically from 1000 to 1500 X10⁻¹⁰m.

Referring to Figure 6, a masking layer 62 of photoresist is patterned in known manner over the silicon nitride layer 56, the masking layer 62 exposing a surface region 64 of the nitride layer 56 above the region 60 of the silicon substrate 58.

Referring to Figure 7, in the same manner as described with reference to the first embodiment, an isolation trench 66 is then etched into the silicon substrate 58, the portions of the nitride and oxide layers 56,54 which are exposed by the masking layer 62 being etched in a common etching step together with the isolation trench 66 or alternatively being etched in two successive etching steps. The isolation trench 66 as so formed has tapered sidewalls 68,70 and a bottom wall 72 as described with reference to the first embodiment. As shown in Figure 7, the sidewall 68,70 and the bottom wall 72 of the isolation trench 66 are subjected to a channel stop implant in the same manner as described with reference to the first embodiment. This forms an implanted region 74 surrounding the isolation trench 66.

Referring now to Figure 8, the masking layer 62 is then removed in known manner. Thereafter, a thin silicon oxide layer 76, preferably having a thickness of from 0.1 to 0.3 microns, is selectively grown in the isolation trench 66, the active areas in the silicon substrate 58 on opposed sides of the isolation trench 66 being masked by the nitride layer 56. It will be noted from Figure 8 that the oxide layer 76 which is grown in the isolation trench 66 is conjoined with the oxide layer 54 under the nitride layer 56 and this enables the selective growth of a thicker oxide in the isolation trench 66 than the oxide layer 54, the thicker parts overlying the top corners of the isolation trench 66 near the active areas of the silicon substrate 58. Thus, thicker oxide regions 78 are present at the edges of the isolation trench 66 and this reduces the possibility of sub threshold current leakage at the active area edges. The thicker oxide regions 78 at the edges of the isolation trench 66 obviates the existence of sharp corners in the active silicon which would tend to cause high electrical fields to be present. Rather, rounded-off corners 88 are provided where the thick oxide layer interfaces with the silicon substrate. The thick oxide layer at the edge ensures that higher threshold voltages for parasitic effects to occur are required because lower electrical fields are produced at the rounded edges of the active areas.

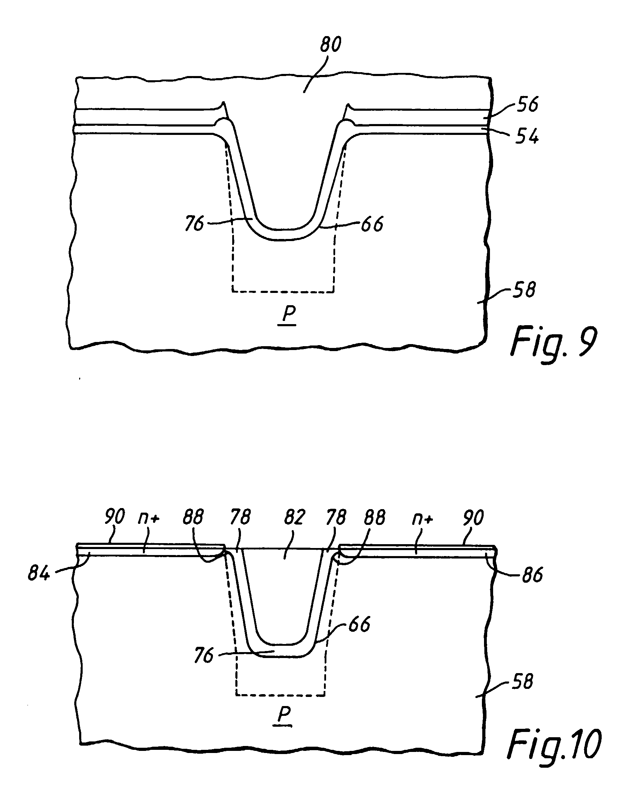

Referring to Figure 9, the isolation trench 66 including the oxide layer 76 is filled with an isolation dielectric layer 80. The dielectric layer 80 is deposited as a blanket layer and preferably comprises a silicon oxide layer.

Referring now to Figure 10, the blanket dielectric layer 80 is then etched in a planarisation etch back step, with the etch being end pointed on the nitride layer 56. The etching step thus ends on the nitride layer 56 which provides an advantage over the first embodiment wherein the etch step ends on the active area silicon, because this avoids etch damage to the active areas. The use of an etch back step end pointed on nitride permits an increase in the degree of planarisation of the semiconductor device by reducing the step height between the active area and the isolation region. The etch back process leaves a residual isolation dielectric 82 covering the oxide layer 76 in the trench 66. A chemical mechanical polishing step may be used instead of an etch back step. Subsequently, as shown in Figure 10 the nitride and oxide layers 56,54 covering the substrate 58 are removed and then dopant is introduced into the surface of the silicon substrate 58 on opposed sides of the isolation trench 66 to form implanted active areas, such as the n⁺-doped source and drain regions 84,86 illustrated in Figure 10. Thereafter, a gate oxide layer 90, typically around 10 nm thick, is grown over the source and drain regions 84,86. The device is then subjected to conventional processing, for example the formation of gates on the gate oxide layer 90 and the formation of insulation and metallisation layers. The gate oxide layer 90 is thinner than the silicon oxide layer 76 in the isolation trench 66.

The present invention, in providing a tapered trench, enables threshold voltage adjust implants reliably to be achieved using a single step so as efficiently to manufacture efficient semiconductor devices incorporating isolation trenches with reduced possibility of undesired current leakages.

## Claims

1. A semiconductor device comprising a silicon substrate (8), two spaced active areas (4,6) in a surface of the substrate (8), an isolation trench (14) of isolating material (26) located between the active areas (4,6) and extending downwardly into the silicon substrate (8), the isolating material (26) including a layer (26) of silicon oxide adjacent to the silicon substrate (8), the interface between the layer (26) of silicon oxide and the silicon substrate (8) at the top of the isolation trench (14) being rounded, and a body (30) of insulating material filling the remainder of the trench (14), and a doped area (24) comprising a threshold voltage adjusting region which surrounds the isolation trench (14), the isolation trench (14) having sidewalls (18,20) and a bottom wall (16), the doped area (24) having an implanted dopant which has been implanted into the sidewalls (18,20) and bottom wall (16) of the isolation trench (16), characterised in that the sidewalls (18,20) are inwardly tapered at an angle of from 5 to 20° to the vertical, and the isolation trench (14) has a depth of from 0.5 to 5.0 microns and a width of around 0.8 microns.

2. A semiconductor device according to claim 1 wherein the layer (78) of silicon oxide at the top of the isolation trench (14) is thicker than an adjacent gate oxide layer (54).

3. A semiconductor device according to claim 1 or claim 2 wherein the layer (26) of silicon oxide has a thickness of from 0.1 to 0.3 microns.

4. A method of manufacturing a semiconductor device incorporating an isolation trench (66), the method comprising the steps of:
(a) providing a silicon substrate (58), a lower silicon oxide layer (54) over the substrate and an etch stop layer (56) over the silicon oxide layer (54);
(b) etching an isolation trench (66) downwardly into the etch stop layer (56), the silicon oxide layer (54) and the silicon substrate (58), the etching being carried out whereby the isolation trench (66) has sidewalls (68,70) and a bottom wall (72);
(c) implanting an implant into the sidewalls (68,70) and bottom wall (72) of the isolation trench (66);
(d) filling the trench (66) with isolating material by growing silicon oxide (76) in the trench adjacent the silicon substrate (58) and filling the remainder of the trench with a body (82) of insulation material, the layer (76) of silicon oxide in the isolation trench (66) being grown so as to be joined with the lower silicon oxide layer (54) at junctions along opposed sides of the trench (66) whereby the conjoined oxide layer (78) has an increased thickness portion thereof at the junctions; and
(e) at any stage in the method, defining active areas (84,86) in the silicon substrate (58) which are on opposed sides of the isolation trench (66) in the resultant semiconductor device,
characterised in that the etching step (b) is carried out whereby the sidewalls (68,70) are inwardly tapered at an angle of from 5 to 20° to the vertical and the isolation trench (66) has a depth of from 0.5 to 5.0 microns and a width of around 0.8 microns and the implanting step (c) uses a single implant substantially perpendicular to the upper surface.

5. A method according to claim 4 wherein the layer (76) of silicon oxide is grown selectively in the trench (66) and has a thickness of from 0.1 to 0.3 microns.

## Patentansprüche

1. Halbleitereinrichtung mit einem Siliziumsubstrat (8), zwei beabstandeten aktiven Bereichen bzw. Flächen (4, 6) in einer Oberfläche des Substrates (8), einem Isolations- bzw. Trenngraben (14) aus trennendem bzw. isolierendem Material (26), der zwischen den aktiven Bereichen bzw. Flächen (4, 6) angeordnet ist und abwärts in das Siliziumsubstrat (8) erstreckt ist, wobei das Isolations- bzw. Trennmaterial (26) eine Schicht (26) aus Siliziumoxid benachbart zu dem Siliziumsubstrat (8) enthält, wobei die Schnittfläche bzw. Anschlussfläche zwischen der Schicht (26) aus Siliziumoxid und dem Siliziumsubstrat (8) an dem oberen Abschnitt des Isolations- bzw. Trenngrabens (14) abgerundet ist, und mit einem Körper (30) aus isolierendem Material, der den Rest des Grabens (14) füllt, und mit einer dotierten Fläche bzw. einem dotierten Bereich (24), der einen Bereich zur Einstellung einer Schwellenwertspannung aufweist, der den Isolations- bzw. Trenngraben (14) umgibt, wobei der Isolations- bzw. Trenngraben (14) Seitenwände (18, 20) und eine Bodenwand (16) hat, wobei die dotierte Fläche bzw. der dotierte Bereich (24) ein implantiertes Dotiermittel hat, das in die Seitenwände (18, 20) und die Bodenwand (16) des Isolations- bzw. Trenngrabens (16) implantiert worden ist, dadurch gekennzeichnet, dass die Seitenwände (18, 20) einwärts mit einem Winkel von 5 bis 20° zu der Vertikalen verjüngt sind, und dass der Isolations- bzw. Trenngraben (14) eine Tiefe von 0,5 bis 5,0 µm und eine Breite von um die 0,8 µm hat.

2. Halbleitereinrichtung gemäss Anspruch 1, wobei die Schicht (78) aus Siliziumoxid an dem oberen Teil des Isolations- bzw. Trenngrabens (14) dicker als eine benachbarte Gateoxidschicht (54) ist.

3. Halbleitereinrichtung gemäss Anspruch 1 oder Anspruch 2, wobei die Schicht (26) aus Siliziumoxid eine Dicke von 0,1 bis 0,3 µm hat.

4. Verfahren zur Herstellung einer Halbleitereinrichtung, die einen Isolations- bzw. Trenngraben (66) beinhaltet, wobei das Verfahren die Schritte aufweist:
(a) ein Siliziumsubstrat (58), eine untere Siliziumoxidschicht (54) über dem Substrat und eine Ätzstopschicht (56) über der Siliziumoxidschicht (54) werden zur Verfügung gestellt;
(b) ein Isolations- bzw. Trenngraben (66) wird abwärts in die Ätzstopschicht (56), die Siliziumoxidschicht (54) und das Siliziumsubstrat (58) geätzt, wobei die Ätzung durchgeführt wird, wodurch der Isolations- bzw. Trenngraben (66) Seitenwände (68, 70) und eine Bodenwand (72) erhält;
(c) ein Implantationsmittel wird in die Seitenwände (68, 70) und in die Bodenwand (72) des Isolations- bzw. Trenngrabens (66) implantiert;
(d) der Graben (66) wird mit isolierendem Material durch Aufwachsen von Siliziumoxid (76) in dem Graben benachbart zu dem Siliziumsubstrat (58) gefüllt und der Rest des Grabens wird mit einem Körper (82) aus isolierendem Material gefüllt, wobei die Schicht (76) aus Siliziumoxid in dem Isolations- bzw. Trenngraben (66) so aufgewachsen wird, um mit der unteren Siliziumoxidschicht (54) an Verbindungsbereichen entlang gegenüberliegenden Seiten des Grabens (66) verbunden zu werden, wodurch die überlappende Oxidschicht (78) einen Abschnitt davon mit gesteigerter Dicke an den Verbindungsabschnitten hat; und
(e) in irgendeinem Stadium des Verfahrens werden aktive Bereiche bzw. Flächen (84, 86) in dem Siliziumsubstrat (58) festgelegt, die auf gegenüberliegenden Seiten des Isolations- bzw. Trenngrabens (66) in der sich ergebenden Halbleitereinrichtung sind,
dadurch gekennzeichnet, dass der Ätzschritt (b) ausgeführt wird, wodurch die Seitenwände (68, 70) einwärts mit einem Winkel von 5 bis 20° zu der Vertikalen verjüngt sind und der Isolations- bzw. Trenngraben (66) eine Tiefe von 0,5 bis 5,0 µm und eine Breite von ungefähr 0,8 µm hat, und wobei der Implantationsschritt (c) eine einzige Implantation im wesentlichen senkrecht zu der oberen Oberfläche verwendet.

5. Verfahren nach Anspruch 4, wobei die Schicht (76) aus Siliziumoxid selektiv in dem Graben (66) aufgewachsen wird und eine Dicke von 0,1 bis 0,3 µm hat.

## Revendications

1. Dispositif semiconducteur comprenant un substrat de silicium (8), deux zones actives espacées (4, 6) dans une surface du substrat (8), une tranchée d'isolement (14) relie d'un matériau isolant (26), disposée entre les zones actives (4, 6) descendant dans le substrat de silicium (8), le matériau d'isolement (26) comprenant une couche (26) d'oxyde de silicium voisine du substrat de silicium (8), l'interface entre la couche (26) d'oxyde de silicium et le substrat de silicium (8) au sommet de la tranchée d'isolement (14) étant arrondie, et un corps (30) d'un matériau isolant remplissant le reste de la tranchée (14), et une zone dopée (24) comprenant une région de réglage de tension de seuil qui entoure la tranchée d'isolement (14), la tranchée d'isolement (14) ayant des parois latérales (18, 20) et un fond (16), la zone dopée (24) comportant un dopant implanté qui a été implanté dans les parois latérales (18, 20) et le fond (16) de la tranchée d'isolement (14), caractérisé en ce que les parois latérales (18, 20) sont inclinées vers l'intérieur d'un angle de 5 à 20° par rapport à la verticale, et en ce que la tranchée d'isolement (14) a une profondeur de 0,5 à 5,0 µm et une largeur d'environ 0,8 µm.

2. Dispositif semiconducteur selon la revendication 1, dans lequel la couche (78) d'oxyde de silicium en haut de la tranchée d'isolement (14) est plus épaisse que la couche d'oxyde de grille voisine (54).

3. Dispositif semiconducteur selon la revendication 1 ou 2, dans lequel la couche (26) d'oxyde de silicium a une épaisseur de 0,1 à 0,3 µm.

4. Procédé de fabrication d'un dispositif semiconducteur comprenant une tranchée d'isolement (66), ce procédé comprenant les étapes suivantes :
(a) prévoir un substrat de silicium (58), une couche d'oxyde de silicium inférieure (54) sur le substrat et une couche d'arrêt de gravure (56) sur la couche d'oxyde de silicium (54) ;
(b) graver une tranchée d'isolement (66) vers le bas dans la couche d'arrêt de gravure (56), la couche d'oxyde de silicium (54) et le substrat de silicium (58), la gravure étant effectuée de sorte que la tranchée d'isolement (66) a des parois latérales (68, 70) et un fond (72) ;
(c) implanter un produit d'implantation dans les parois latérales (68, 70) et le fond (72) de la tranchée d'isolement (66) ;
(d) remplir la tranchée (66) de matériau isolant en faisant croître de l'oxyde de silicium (76) dans la tranchée au voisinage du substrat de silicium (58) et en remplissant le reste de la tranchée d'un corps (82) de matériau d'isolement, la couche (76) d'oxyde de silicium dans la tranchée d'isolement (66) étant amenée à croître de façon à rejoindre la couche d'oxyde de silicium inférieure (54) au niveau de points de raccordement le long de côtés opposés de la tranchée (66), d'où il résulte que la couche d'oxyde conjointe (78) comporte une partie d'épaisseur accrue au niveau des points de raccordement ; et
(e) à une étape quelconque du processus, définir des zones actives (84, 86) dans le substrat de silicium (58) qui sont sur des côtés opposés de la tranchée d'isolement (66) dans le dispositif semiconducteur résultant ;
caractérisé en ce que l'étape de gravure (b) est effectuée de sorte que les parois latérales (68, 70) sont inclinées vers l'intérieur d'un angle de 5 à 20° par rapport à la verticale et la tranchée d'isolement (66) a une profondeur de 0,5 à 5,0 µm et une largeur d'environ 0,8 µm, et l'étape d'implantation (c) utilise un implant unique sensiblement perpendiculairement à la surface supérieure.

5. Procédé selon la revendication 4, dans lequel la couche (76) d'oxyde de silicium est amenée à croître sélectivement dans la tranchée (66) et a une épaisseur de 0,1 à 0,3 µm.
